Europäisches Patentamt

European Patent Office

Office européen des brevets

(11) Publication number: **0 312 030**
**A2**

# EUROPEAN PATENT APPLICATION

(21) Application number: **88116961.9**

(51) Int. Cl.⁴: **H03M 7/18**

(22) Date of filing: **12.10.88**

(30) Priority: **12.10.87 JP 257025/87**
**15.10.87 JP 260991/87**
**12.11.87 JP 287101/87**
**12.11.87 JP 287102/87**
**29.12.87 JP 336501/87**

(43) Date of publication of application:
**19.04.89 Bulletin 89/16**

(84) Designated Contracting States:
**AT DE FR GB NL SE**

(71) Applicant: **SONY CORPORATION**
**7-35 Kitashinagawa 6-Chome Shinagawa-ku**
**Tokyo 141(JP)**

(72) Inventor: **Takayama, Jun**
**c/o Sony Corporation 7-35 Kitashinagawa**
**6-chome**
**Shinagawa-ku Tokyo(JP)**
Inventor: **Ninomiya, Takeshi**
**c/o Sony Corporation 7-35 Kitashinagawa**
**6-chome**
**Shinagawa-ku Tokyo(JP)**
Inventor: **Fujita, Tadao**
**c/o Sony Corporation 7-35 Kitashinagawa**
**6-chome**
**Shinagawa-ku Tokyo(JP)**
Inventor: **Inaba, Yoshiaki**
**c/o Sony Corporation 7-35 Kitashinagawa**
**6-chome**
**Shinagawa-ku Tokyo(JP)**

(74) Representative: **Patentanwälte TER MEER -**
**MÜLLER - STEINMEISTER**
**Mauerkircherstrasse 45**
**D-8000 München 80(DE)**

(54) **Method and apparatus for encoding and decoding data in a residue number system.**

(57) An encoder circuit is designed as to convert input data composed of binary codes into RNS data, and provided with
a dividing means for dividing said input data into a plurality of data using fixed bits,
a first ROM table circuit for applying weighted processing to said plurality of data and converting them into residue data for each fixed modulus, and
a second ROM table circuit for converting said addition value of said residue data for each said modulus into residue data of each corresponding modulus.
Said encoder circuit is further designed to output residue data obtained via said second ROM table circuit as residue data composing said RNS data.

EP 0 312 030 A2

FIG. 1

## METHOD AND APPARATUS FOR ENCODING AND DECODING DATA IN A RESIDUE NUMBER SYSTEM

### BACKGROUND OF THE INVENTION

The present invention relates to an encoder and a decoder for residue number system data employed in a digital signal processing circuit using residue operation.

Digital signal processing circuits such as a digital filter and the like using residue operation have been proposed. Refer to "IRE transactions on electronic computers, Vol. EL-8, No.6, June 1959, pp.140-147", "IEEE computer, Vol.17, No.5, May 1984. pp.50-61", and "The transactions of the institute of electronics and communication engineers, '84/4 Vol. J67-1, No.4 pp.536-543".

Since carry in operation becomes unnecessary in a residue number system, operation of digital signals can be carried out with high accuracy and high speed.

Then, after input binary data have been once converted into a set of a plurality of residue data (hereinafter it is called as RNS data), and desired operation has been carried out in a residue number system, the obtained RNS data are converted into output binary data once more.

In this time, if the conversion table is constituted using ROM (Read Only Memory) in the encoder and the decoder for the RNS data, the RNS data and the binary data can be obtained with high speed.

However, in order to convert n-bit binary data into, for example, RNS data represented by the plurality of Ki-bit residue data, a ROM table having a capacity A represented by the following expression is needed with respect to each of modula $m_i$ $(i = 0,1,2,...)$

$$A = 2^n \bullet Ki \text{ [bit]}$$

For example, when the binary data and the residue data are represented by 14 bits and 4 bits, respectively, the capacity of the value represented by the following expression is needed.

$$A = 2^{14} \times 4 = 65536 \text{ [bit]}$$

There has been a problem that when a capacity of a ROM table is made large in this way, the access time of the ROM table is made so much the longer so that it is difficult to convert binary data into RNS data.

Also, as a method by which RNS data are demodulated into binary data, a Mixed Radix Conversion Method (hereinafter called as MRC method) is known as shown in the paper entitled " residue arithmetic and its application to computer technology (1967)".

In this method, residue data composing RNS data are applied with scale-down processing in order step by step using a multiplicative inverse element of a value of one modulus for that of the other modulus to reduce the number of the residue data, and after residue data remaining finally have been applied with processing of multiplication using a fixed modulus, the RNS data are converted to binary data by obtainng addition data.

In this case, however, since the residue data are applied with scale-down processing in order step by step, there is a problem that the whole configuration becomes large-scaled.

Also, there has been another problem that though a negative number can be represented by 2's complement binary against natural or straight binary in binary data, a negative number is not particularly defined in RNS data, and, therefore, processing of operation becomes complicated.

### OBJECTS AND SUMMARY OF THE INVENTION

Accordingly, the object of the present invention is to provide a new encoder and a new decoder for RNS data each of which solves the conventional defects described previously.

In particular, the object of the present invention is to provide an encoder and a decoder for RNS data, each of which has a compact configuration on the whole and a rapid conversion speed.

Another object of the present invention is to provide an encoder and a decoder for RNS data which allow processing of operation to be simplified by defining a positive number and a negative number in RNS data.

## BRIEF DESCRIPTION OF THE DRAWINGS

Fig.1 is a rough sketch view showing the relation between binary data and RNS data in an encoder and a decoder according to the present invention;

Fig.2 is a block diagram showing digital processing devices such as digital fiter and the like to which the encoder and the decoder according to the present invention are applied;

Fig.3 is a block diagram showing the principle of the encoder for residue data according to the present invention;

Fig.4 is a block diagram showing an embodiment of the encoder for residue data according to the present invention;

Fig.5 is a block diagram showing the principle of the decoder for residue data according to the present invention;

Fig.6A and Fig.6B are block diagrams showing an embodiment od the decoder for residue data according to the present invention; and

Fig.7 is a shematic diagram explanatory of the operation of the decoder for residue data according to the present invention.

## DETAILED DESCRIPTION OF THE PREFERRED EMBODIMENT

At first, the relationship betwen binary data and RNS data will be shown based on, for example, a Chinese remainder theorem.

In other words, according to the Chinese remainder theorem, if a remainder $R_i$ of X with regard to the modulus $m_i$ is represented by the following expression (1) using a mark MOD,

$$R_i = X \text{ MOD } m_i \quad (1)$$

RNS data $D_{R0}$ represented by the values $R_0$, $R_1$, $R_2$,---$R_i$, of remainder data pertaining to the modulus $m_0$ $m_1$, $m_2$, ---$m_i$, correspond to binary data having the value B represented by the following expression (5) using the values M, Mi, and Ni which are represented by the following relations (2), (3), and (4), respectively.

$$M = \pi m_i \quad (2)$$
$$M_i = M/m_i \quad (3)$$
$$I = N_i \cdot M_i \text{ MOD } m_i \quad (4)$$
$$B = (\Sigma R_i \cdot M_i \cdot N_i) \text{MOD } M \quad (5)$$

In this case, the binary data and the RNS data have one-to-one correspondence in the range which is not over the dynamic range M of the RNS data.

If, in processing of operation of the residue data composing the RNS data, the same procedure as in the case where binary data are represented by 2′complement can be employed for the processing of operation, the configuration of the circuit for processing of operation can be made so much the simpler.

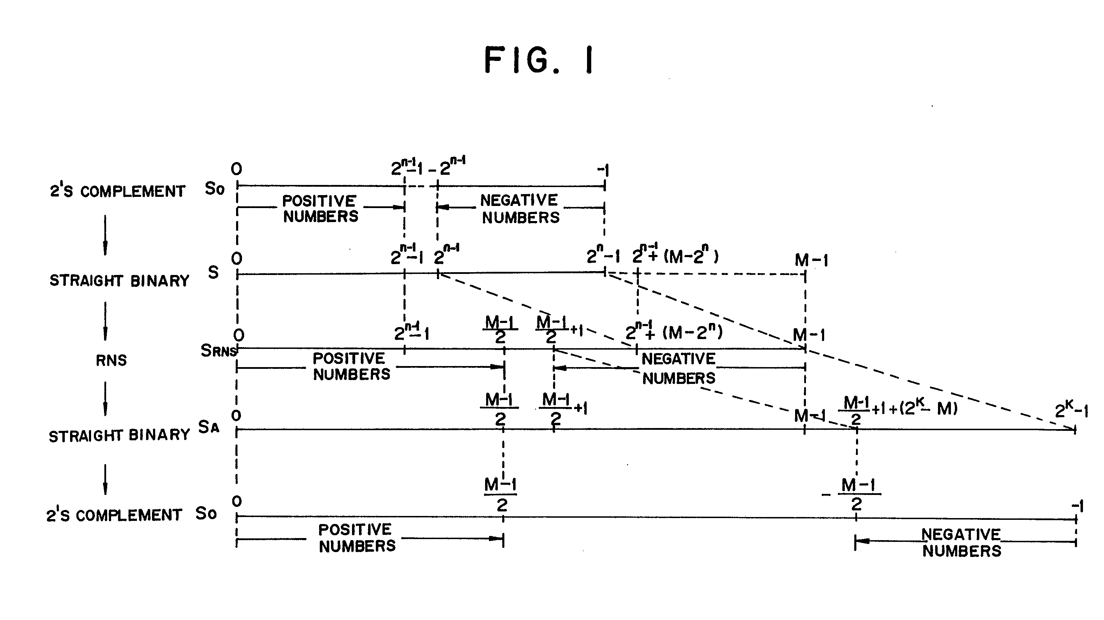

As shown in Fig.1, in general, n-bit straight binary data can represent decimal digits of 0 to $2^n-1$, and n-bit binary data of 2′ complement can represent decimal digits of $-2^{n-1}$ to $2^{n-1}-1$. On the other hand, RNS data can represent decimal digits of 0 to M-1 in tatal using a dynamic range M shown by the expression (2). Then, the region of the RNS data is assigned to regions of positive numbers and negative numbers correspondingly to Z's complement binary data.

In the case where M is odd, the region that, the value $S_{RNS}$ represented by the RNS data is 0 to $\frac{M-1}{2}$ represents positive numbers and negative numbers are represented by in the region from the value $\frac{M-1}{2} + 1$ to the value M-1.

The decimal digit $2^n-1$ represented by the straight binary data is a decimal digit of -1 in the binary data of 2′ complement. When this is represented by RNS data, it becomes RNS data corresponding to complement representation of M-1 for a decimal digit M.

Since the expression

$$2^n-1 + (M - 2^n) = M-1 \quad (11)$$

holds, when the value S of the straight binary data is in the range of $0 \leq S \leq 2^{n-1}-1$, the residue data having

3

the value Ri represented by the following expression (12) constitute RNS data.

$$Ri = S \text{ MOD } m_i \qquad (12)$$

When the value S is in the range of $2^{n^{-1}} \leq S \leq 2^n\text{-}1$, the residue data having the value Ri represented by the expression (13) constitute RNS data.

$$Ri = (S + M - 2^n) \text{ MOD } m_i \qquad (13)$$

In other words, a positive or negative number is distinguished by the most significsnt bit of binary data. When the value of the most significant bit is zero ( that is, when it is a positive number), residue data of each modulus mi are calculated from the binary data concerned. When the value of the most significant bit is 1 (that is, it is a negative number), after natural binary data are added with the fixed value ( that is, the value $M - 2^n$) in such a manner that the maximum value $2^{n^{-1}}$ of the natural binary data (that is, the value represented by binary data of 2's complement - 1) becomes the maximum value M - 1 of the RNS data ( that is, the value represented by the RNS data -- 1), residue data of each modulus are calculated.

On the contrary, when RNS data are converted into binary data of 2's compliment, k-bit binary data capable of representing the larger value than the dynamic range M of the RNS data are made to correspond to the RNS data. When the value $S_A$ of natural binary data decoded by the MRC method is in the range of $0 \sim (M\text{-}1)/2$, the value $S_A$ is judged to be a positive number, and k-bit binary data of 2's complement are obtained as they are. When the value $S_A$ is in the range of $(M\text{-}1)/2 + 1 \sim (M\text{-}1)$, the value $S_A$ is judged to be a negative number, and binary data of 2's complement are obtained by adding the value $2^k\text{-}M$ to the value $S_A$ of the natural binary data which have been decoded in such a manner that the maximum value M-1 of the value $S_A$ of the binary data obtained by decoding the RNS data having the dynamic range M becomes the maximum value $2^k\text{-}1$ of the value $S_A$ of the k-bit binary data, that is, the value of the k-bit binary data of 2's complement - 1.

Next, hereinafter embodiments of an encoder and a decoder for RNS data according to the present invention will be described in detail with reference to drawings.

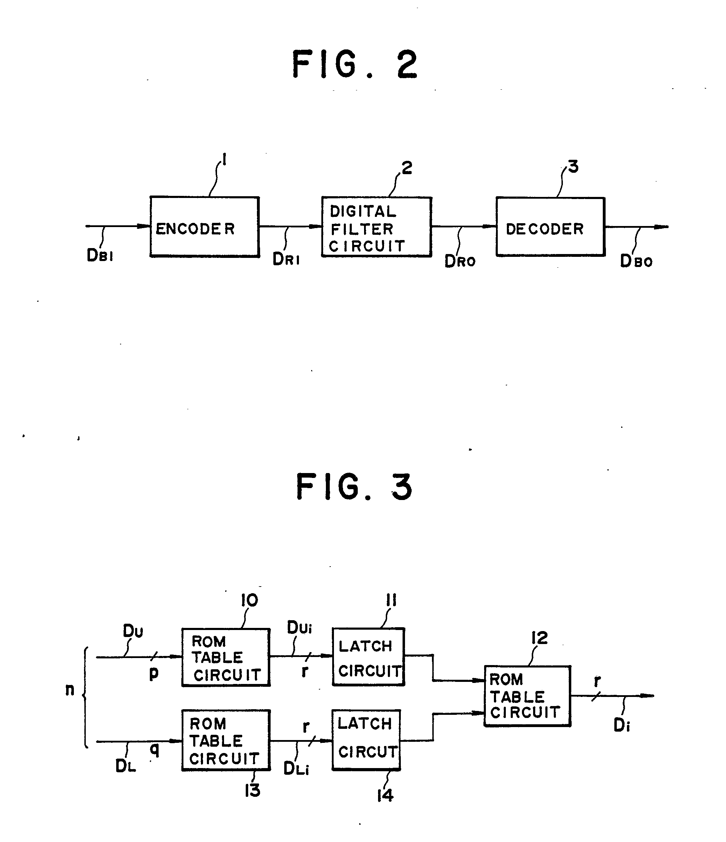

At first, Fig. 2 shows a signal processing circuit using residue operation. In Fig.2, input binary data $D_{BI}$ are supplied to an encoder 1 in which they are divided by positive integers $m_0$, $m_1$, $m_2$,---- $m_i$ having mutually prime relation, and the residue data corresponding respectively to the integers $m_0$, $m_1$, $m_2$ $m_3$, --, $m_i$ are output to a digital filter circuit 2 as RNS data $D_{RI}$.

In the digital filter circuit 2, the plurality of digital filters corresponding to each figure of the RNS data $D_{RI}$ are independently provided, operation of the RNS data $D_{RI}$ is carried out for each figure under each modulus. Accordingly, desired processing of operation for the binary data can be executed with remarkably high speed compoared with that in direct processing of operation for the binary data.

The residue data output from the digital filters in the digital filter circuit 2 are supplied to a decoder 3 as the RNS data $D_{R0}$ and converted into output binary data $D_{B0}$ therein.

Here, though the digital filter circuit 2 is composed of the plurality of digital filters, one digital filter may be employed in time sharing instead of the circuit 2.

Fig.3 shows the principle of conversion of binary data into RNS data in an encoder for residue data according to the present invention, in which residue data Di of the modulus $m_i$ composing RNS data are obtained.

In other words, the n-bit straight binary data having the value S are divided into the p-bit data Du having the value Su (hereinafter it is called as the upper bit data) and the q-bit data $D_L$ having the value $S_L$ - (hereinafter it is called as the lower bit data).

That is, the value S of the binary data can be represented by the following relation (6).

$$S = Su \times 2^q + S_L \qquad (6)$$

The value Ri of the residue data of the modulus m corresponding to the value S concerned can be represented by the following relation (7).

$$Ri = (Su \times 2^q + S_L) \text{ MOD } m_i$$
$$= \{(Su \times 2^q) \text{ MOD } m_i + S_L \text{ MOD } m_i\} \text{ MOD } m_i \qquad (7)$$

In other words, a ROM table 10 receives the upper bit data Du and outputs residue data $D_{ui}$ having the value Rui represented by the relation (8) to a ROM table 12 via a latch 11.

$$Rui = (Su \times 2^p) \text{ MOD } m_i \qquad (8)$$

On the other hand, a ROM table 13 receives lower bit data $D_L$ and outputs residue data DLi having the value RLi represented by the relation (9) to a ROM table 12 via a latch 14.

$$RLi = S_L \text{ MOD } m_i \quad (9)$$

The ROM table 12 outputs the residue data Di having the value Ri represented by the following expression (10) based on the residue data Dui and $D_{Li}$ as residue data of the modulus $m_i$ composing the RNS data.

$$R_i = (Rui + RLi) \text{ MOD } m_i \quad (10)$$

Accordingly, as shown by the expressions (8), (9), and (10), the residue data Di of the norm $m_i$ can be obtained from the added values of the residue data Dui of the modulus $m_i$ obtained after giving weight of the value (that is, the value $2^q$) corresponding to the upper bit data Du concerned to the upper bit data Du and the residue data DLi of the modulus $m_i$ obtained from the lower bit data DL, thereby allowing the residue data Di of the modulus $m_i$ converted into the RNS data from the binary data to be obtained.

At that time, if the value of the modulus $m_i$ is selected in such a manner that the bit length Ki of the residue data Di becomes equal to $\gamma$ bit, in the ROM tables 10 and 13, the capacities of the values represented by expressions $A_1 = 2^p \times \gamma$ and $A_2 = 2^q \gamma$ are needed, respectively. On the other hand, in the ROM table 12 the capacity of the value represented by the expression $A_3 = 2^{2r} \times \gamma$ is needed. Accordingly, a ROM table having capacity of $A_1 + A_2 + A_3 = (2^p + 2^q + 2^{2r}) \times \gamma$ in total is needed in order to obtain the residue data Di of the modulus $m_i$.

However, for example, a ROM having the capacity of 65536 (bit) has been needed until now in the case where four-bit residue data composing RNS data are obtained from 14 bit binary data. For this, the capacity needed can be reduced to that of 3070 (bit),and the configuration of the encoder circuit is formed so much the simpler on the whole, allowing RNS data to be obtained with high speed.

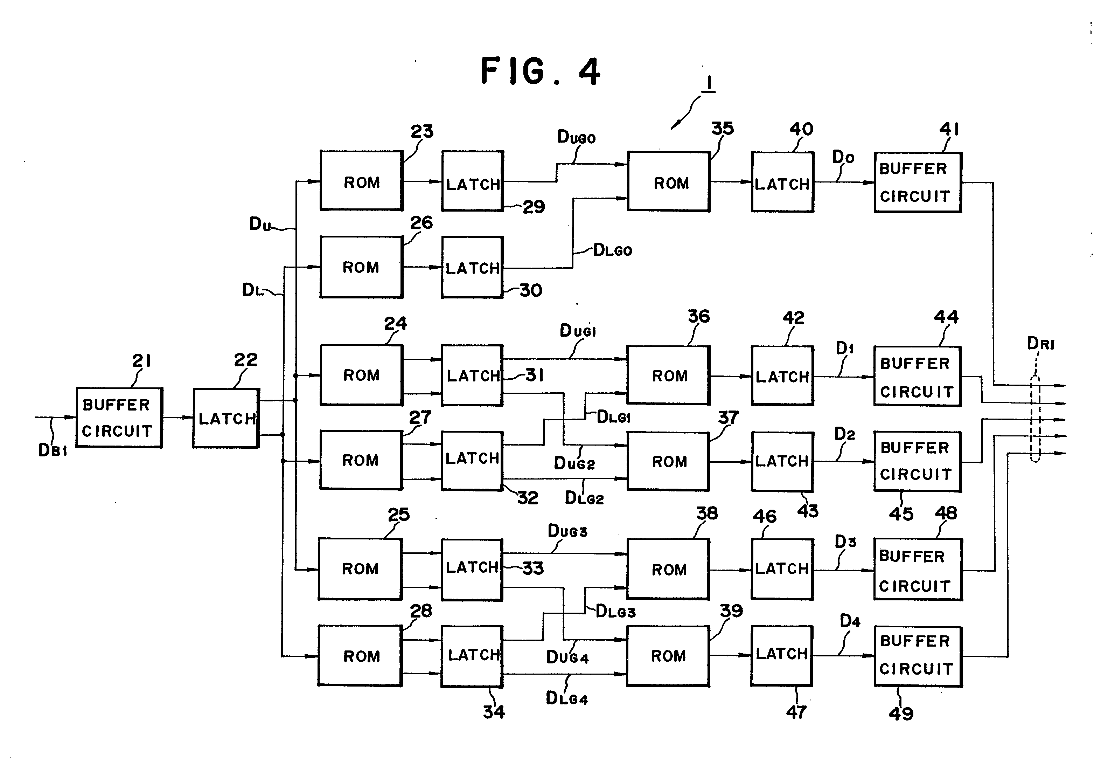

Next, a specific example of an encoder 1 will be described. In Fig.4, the encoder circuit 1 outputs RNS data $D_{RI}$ composed of the residue data Do ~ D4 having the values 7, 11, 13, 15, and 16 of five modulus $m_0$ ~ $m_4$, from digital image signal $D_{BI}$, for example, composed of binary data.

In other words, in the encoder circuit 1, 14-bit binary data represented by 2's complement are received in a latch 22 via a buffer circuit 21 and separated into upper bit data Du and lower bit data DL both comprising 7 bits, and the separated data are supplied to ROMs 23, 24, and 25, and ROMs 26. 27, and 28, respectively.

Thus, the buffer circuit 21 and the latch 22 divide input data $D_{BI}$ comprising binary data for each desired bit number,and, in this case, they form a data dividing means which outputs a plurality of data comprising of upper bit data and lower bit data.

The ROMs 26, 27, and 28 output residue data comprising the lower bit data $D_L$ of the respective modulus $m_0$, that is, its value is 7, $m_1$ and $m_2$, that is their values are 11 and 13 respectively, and $m_3$ and $m_4$, that is, their values are 15 and 16 respectively. The ROMs 23, 24, and 25 output residue data comprising the upper bit data Du of the respective modulus $M_0$, $m_1$ and $m_2$, and $m_3$ and $m_4$.

Thus, the residue data separated into the upper bit data Du and the lower bit data $D_L$ are output, allowing the capacity of the ROM tables needed for conversion of the RNS data to be reduced on the whole, and an encoder having a fast conversion speed with a simple configuration on the whole to be obtained.

In the ROMs 24, 25, 27, and 28, one ROM is provided with two conversion tables so as to output residue data of modulus $m_1$ and $m_2$, and residue data of modulus $m_3$ and $m_4$. This is for effective utilization of the capacity of the ROM. Accordingly, respective conversion tables may be provided in independent ROMs.

In the case where the residue data are separated into the upper bit data Du and the lower bit data DL and converted by the ROM, the value in the parenthesis of the expression (13) can be rewritten into the following relation, that is,

$$
\begin{aligned}
S + M - 2^n &= (Su \cdot \times 2^q + S_1) + M - 2^n \\
&= (Su \times 2^q + M - 2^n) + S_L \\
&= (Su \times 2^q) + (M - 2^n + S_L) \quad \cdots \cdots (14)
\end{aligned}
$$

For example, for the lower bit data $D_L$, the residue data DLGi having the value RLi represented by the expression (9) are output. On the contrary, for the upper bit data Du, the region of positive numbers and that of nagative numbers are defined by the value Su of the data Du, and when the value Su is in the range of $0 \leq Su \leq 2^{p-1}-1$, the residue data DLGi having the value Rui represented by the relation (15) are output, and when the value Su is in the range of $2^{p-1} \leq Su \leq 2^{p-1}$ the remainder data DLGi having the value Rui represented by the relation (16) are output.

$$Rui = (Su \times 2^b) MOD\ m_i \qquad (15)$$
$$Rui = (Su \times 2^{qn}) MOD\ m_i \qquad (16)$$

Thus, the residue data having the value obtained by adding the value of the residue data DuGi to that of the residue data DLGi are obtained, and when positive and negative numbers are represented correspondingly to positive and negative numbers of binary data, RNS data can be obtained.

In the case where RNS data are converted using the way of thinking described previously, after the above- mentioned 14-bit binary data are subjected to rounding to 13-bit binary data in advance, the ROMs, 26, 27, and 28 which receive the lower bit data $D_L$ are made to output residue data having the value RLGi represented by the following expression (17) in place of the residue data having the value represented by the expression (9).

$$RLGi = (SL + 1)/2\ MOD\ m_i \qquad (17)$$

This means that lower bit data of 7 bits are subjected to rounding to 6-bit data in advance on the whole by adding the value 1 to the lowest bit of lower bit data $D_L$ and then omitting the lowest bit concerned, and the residue data DLGi are output with respect to the rounded 6-bit data concerned.

On the other hand, the ROMs 23, 24, and 25 which receive the upper bit data Du carry out processing of weighting of the value $2^6$ corrsponding to processing of rounding the lower bit data $D_L$ to 6 bits, and output the residue data DuGi having the value RuGi represented by the relation (18) when the value Su is in the range represented by the relation $0 \leq Su \leq 63 = 2^{7-1}-1$.

$$RuGi = (Su \times 2^6) MOD\ m_i \qquad (18)$$

On the other hand, when the value Su of the upper bit data Du concerned is in the range represented by the relation $64 \leq Su \leq 127 = 2^7-1$. the residue data DuGi having the value RuGi represented by the relation (19) are output.

$$RuGi = (Su \times 2^6 + M - 2^{13}) MOD\ m_i \qquad (19)$$

Here, the value M is represented by the following expression (20) from the expression (2).

$$M = \prod_{j=0}^{4} m_j$$

$$= 7 \times 11 \times 13 \times 15 \times 16$$
$$= 240240 \qquad (20)$$

Accordingly, since the residue data have been subjected to rounding to 13 bits, they can represent the positive numbers from the value 0 to the value 8191 when the value S of the whole of the binary data is in the range from the value 0 to the value 8191, and the nagative numbers from the value -8191 to the value -1 when the value S is in the range from the value 8192 to the value 16383.

Accordingly, like in this embodiment, even in the case where a digital video signal $S_N$ having the bit length of either of 13 bits and 14 bits is input by receiving a 14-bit digital video signal $S_{BI}$ and processing of rounding it to 13 bits in advance, the video signal $S_{BI}$ can be converted into RNS data with practically sufficient accuracy.

Thus, the ROMs 23, 24, 25, 26, 27 and 28 give weight of the value $2^6$ and the value $2^{\cdot}$ to the upper bit data Du and the lower bit data $D_L$, respectively, and form a first ROM table circuit for converting the upper and lower bit data $D_L$ and $D_L$ into residue data DuG0, DuG1, DuG2, DuG3, DuG4, DLG0, DLG1, DLG2, DLG3, and DLG4 every five norms $m_0 \sim m_4$.

A ROM 35 receives, via latchs 29 and 30, the residue data DuG0 and DLG0 of the upper bit data Du and the lower bit data DL of the modulus 7 which are output from the ROM 23 and the ROM 26 respectively and outputs, via a latch 40 and a buffer circuit 41, the residue data Do having the value represent by the expression (10) based on the residue data DuG0 and DLG0 concerned.

On the other hand, ROMs 36 and 37 receive, via latches 31 and 32, the residue data DuGi and DLGi of the upper bit data Du and the lower bit data DL of the modulus 11 and 13 which are output from the ROMs 24 and 27 respectively and output, via latches 42 and 43 and buffer circuits 44 and 45, the residue data $D_1$

6

and $D_2$ having the values represented by the expression (10) in the same way as the ROM 35.

ROMS 38 and 39 receive, via latches 33 and 34, the residue data DuG3 and DLG3, and DuG4 and DLG4 of the upper bit data Du and the lower bit data $D_L$ of the modulus 15 and 16 which are output from the ROMs 25 and 28 respectively and output, via latches 46 and 47 and buffer circuits 48 and 49, the residue data $D_3$ and $D_4$ having the values represented by the expression (10).

Thus, the residue data $D_0 \sim D_4$ of the modulus 7, 11, 13, 15, and 16 are obtained via the buffer circuits 41, 44, 45, 48, and 49, and RNS data $D_{RI}$ comprising the residue data $D_0 \sim D_4$ concerned can be obtained. Thus, the ROMs 35, 36, 37, 38, and 39 form a second ROM table circuit which converts the added values of the residue data $D_{uG0}$, $D_{LG0}$, $D_{uG1}$, $D_{LG1}$, $D_{uG2}$, $D_{LG2}$, $D_{UG3}$, $D_{LG3}$, $D_{UG4}$, and $D_{LG4}$ every the modulus $m_0$, $m_1$, $m_2$, $m_3$, and $m_4$ into the corresponding residue data $D_0$, $D_1$, $D_2$, $D_3$, and $D_4$ of the norms $m_0$, $m_1$, $m_2$, $m_3$, and $m_4$.

With the above configuration, in obtaining the residue data bssed on the fixed norms using the ROM table circuits, the residue data are separated into the upper bit data and lower bit data and then processed, thereby allowing capacities of the ROM table circuits to be reduced.

Accordingly, the configuration of the whole of the encoder circuit can be made so much the simpler, allowing the conversion speed to be made high.

In the above-mentioned embodiment, the case where the lower bit data have been subjected to processing of rounding has been described. But, the present invention is not restricted to this case, but the processing of rounding has only to be carried out as required.

Further, in the above-mentioned embodiment, the case where the 14-bit binary data have been separated into the upper bit data of 7 bits and the lower bit data of 7 bits and then processed has been described. But, the bit length to be separated is not restricted to 7 bits, for example, the binary data may be separated into data of 6 bits and 8 bits, and the bit value can be selected to a desired value as required.

Further, in the above-mentioned embodiment, the case where the binary data are separated into two kinds of data, that is, the upper bit data and lower bit data for processing has been described. But, the present invention is not restricted to this, for eample, the binary data may be separated into three kinds of data, or the binary data may be separated into plural kinds of data for processing as required.

Next, the decoder 3 will be described. The decoder 3 receives RNS data $D_{RO}$ output from the digital filter circuit 2 and outputs binary data $D_{Bo}$, based on, for example, such the MRC method as described previously.

The MRC method will be described more in detail. At first, with respect to the residue $R_i$ of S pertaining to the modulus $m_i$ shown in the expression (1), assuming that S is generally represented by X, the value Xi represented by the following expression (21) is defined to be a multiplicative inverse element of X pertaining to the modulus m .

$$1 = (Xi \cdot X) \bmod m_i \qquad (21)$$

provided that $0 \leq x \leq m_i$

Then, the value Rij is obtained, which satisfies the expression (22) represented using the values Ri and Rj of the residue data pertaining to the moduli $m_i$ and $m_j$ and the multiplicative inverse element Xij of the value $m_j$ pertaining to the modulus $m_i$.

$$Rji = \{(Ri - Rj)Xij\} \bmod m_i \qquad (22)$$

This processing is called as a scale-down processing pertaining to the modulus $m_j$ in the present specification.

The scale-down processing is parallelly repeated in sequence for predetermined residue data to gradually reduce the number of residue data which require the scale-down processing and obtain a plurality of residue data corresponding to the modulus of the RNS data. After the residue data are multiplicatively processed using a predetermined modulus, added data are obtained, thereby converting the RNS data into binary data.

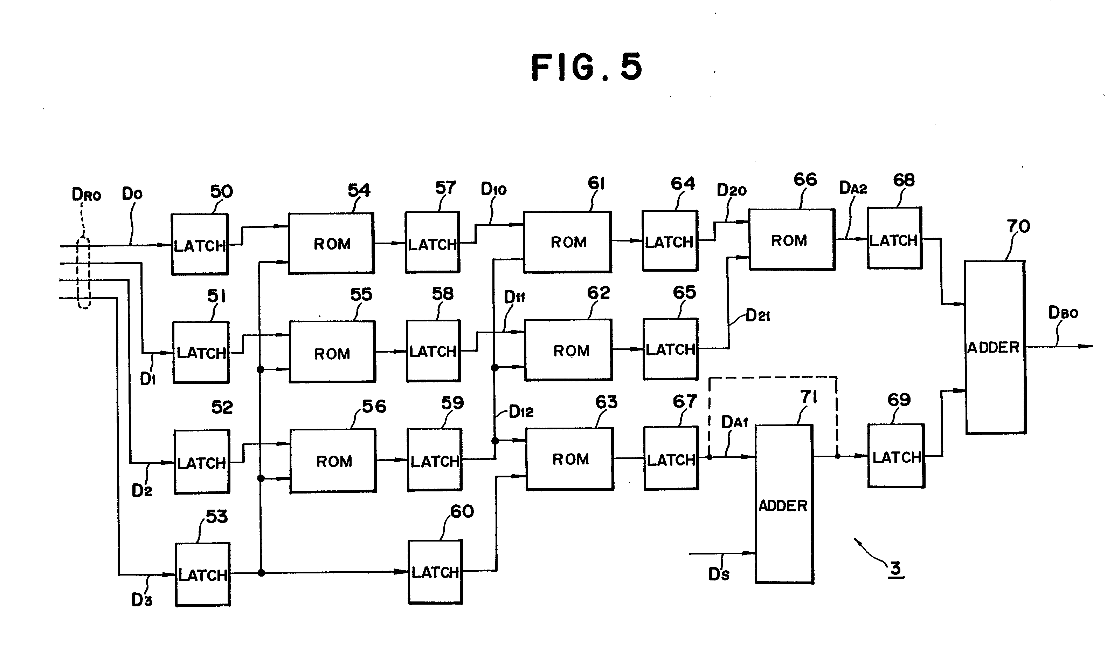

The fundamental principle of the decoder will be explained using Fig.5. Residue data D0, D1, and $D_2$ pertaining to the moduli m0, m1, and $m_2$ among RNS data consisting of residue data D0, D1, $D_2$, and $D_3$ pertaining to the moduli m0, m1, $m_2$, and $m_3$ which are provided via latch circuits 50, 51, 52, and 53 are supplied to ROM table circuits 54, 55, and 56.

Furthermore, ROM table circuits 54, 55, and 56 receive residue data $D_3$ pertaining to the modulus $m_3$ via the latch circuit 53.

The ROM table circuit 54 outputs residue data D10 having the value R10 based on the expression (22) using a multiplicative inverse element X03 of the value $m_3$ (that is, the modulus of the residue data $D_5$) pertaining to the modulus m0 with the values of the residue data D0 and $D_3$ set at R0 and $R_3$. The ROM table circuit 55 outputs residue data D11 having the value R11 based on the expression (22) using a multiplicative inverse element X13 of the value $m_3$ pertaining to the modulus mi with the value of the residue data D1 set at R1. The ROM table circuit 56 outputs residue data D12 having the value R12 based on the expression (22) using a multiplicative inverse element $X_{23}$ of the value $m_3$ pertaining to the modulus $m_2$ with the value of the residue data D set at R .

The outputs of the ROM table circuits 54, 55, and 56 and the latch circuit 53 are again provided to ROM table circuits 61, 62, and 63 via latch circuits 57, 58, 59, and 60. The ROM table circuit 61 receives the residue data D10 and D12 and outputs residue data D20 having the value R20 based on the expression (22) using a multiplicative inverse element X02 of the value $m_2$ pertaining to the modulus m0.

The ROM table circuit 62 outputs receives the residue data $D_{11}$ and $D_{12}$ and outputs residue data $D_{21}$ having the value $R_{21}$ based on the expression (22) using a multiplicative inverse element $X_{12}$ of the value $m_2$ pertaining to the modulus m1.

On the other hand, the ROM table circuit 63 receives the residue data $D_3$ and $D_{12}$ and outputs addition data $D_{A1}$ of the value $S_{A1}$ represented by the following expression (23).

$$S_{A1} = R_{12} \cdot m_3 + R_3 \qquad (23)$$

The outputs of the ROM table circuits 61 and 62 are supplied to a ROM table circuit 66 via latch circuits 64 and 65.

The ROM table circuit 66 receives the residue data $D_{20}$ and $D_{21}$ and outputs addition data $D_{A2}$ of the value $S_{A2}$ represented by the following expression (24).

$$S_{A2} = R_{20} \cdot m_1 \cdot m_2 \cdot m_3 + R_{21} \cdot m_2 \cdot m_3 \qquad (24)$$

The outputs of the ROM table circuits 63 and 66 are provided to an addition circuit 70 via latch circuits 67, 68, and 69 to obtain output data represented by a binary code of the value $S_A$ represented by the following relation (25).

$$S_A = S_{A1} + S_{A2} = R_{20} \cdot m_1 \cdot m_2 \cdot m_3 + R_{21} \cdot m_3 + R_3 \qquad (25)$$

In other words, RNS data $D_{R0}$ consisting of the residue data $D_0 \sim D_3$ of the moduli $m_0 \sim m_3$ are converted into binary data $D_{Bo}$.

Next, the principle of the embodiment of the decoder circuit according to the present invention will be explained. In the present invention, the modulus of the value of the power of 2, that is, $2^l$ is applied to the modulus of residue data which are firstly scale-down processed. Thus, if addition data of the value $S_b$ represented by the following relation (26) is made to output from the expression (25), the RNS data $D_{R0}$ can be demodulated into the binary data $D_{Bo}$.

$$S_B = R_{20} \cdot m_1 \cdot m_2 \cdot 2^l + R_{21} \cdot m_2 \cdot 2^l + R_{12} \cdot 2^l + R_3 \qquad (26)$$

This means that the values $m_1 \cdot m_2 \cdot m_3$, $m_2 \cdot m_3$, and $m_3$ are not be multiplicatively processed for the values $R_{20}$, $R_{21}$, and $R_{12}$ of the residue data $D_{20}$, $D_{21}$, and $D_{12}$ respectively in the first, second and third terms of the right side of the expression (26), but even if bit shift is carried out by the value $l$ of the exponential part of the modulus $m_3$ represented by a power of 2 to add it to the residue data $R_3$ after the values $m_1$, $m_2$, $m_2$, and 1 are multiplicatively processed, the RNS data can be demodulated. This also means that operation processing works in demodulating the RNS data can be simplified so much.

Concretely, the ROM table circuit 66 outputs addition data $D_{R2}$ represented by the relation (27) to an adder 70.

$$S_{B2} = R_{20} \cdot m_1 \cdot m_2 + R_{21} \cdot m_2 \qquad (27)$$

Furthermore, the ROM table circuit 63 is omitted and made to output residue data $D_3$ and $D_{12}$ directly to the adder 70 via a predetermined latch circuit (not shown).

In the adder 70, the addition data $D_{R2}$ and the residue data $D_{12}$ are bit-shifted by $l$ bits toward the higher order bit side, and the residue data $D_3$ and $D_{12}$ are added with the addition data $D_{R2}$ respectively to output them.

Accordingly, addition data having the value $S_R$ represented by the following relation (28) can be obtained via the adder 70. It is found that substituting the expression (27) into the expression (28), binary data $D_{B0}$ demodulated based on the MRC method can be obtained.

$$S_B = S_{R2} \cdot 2^l + R_{12} \cdot 2^l + R_3 \qquad (28)$$

Thus, by having selected the modulus $m_3$ which firstly carries out scale-down processing to the value $2^l$ represeted by a power of 2, the ROM table circuit 63 which outputs residue data represented by the third term of the right side of the expression (26) can be omitted.

Moreover, in the ROM table circuit 30, though the modulus $m_3$ has to be multiplicatively processed corresponding to the first and second terms of the right side of the expression (25), it is sufficient to output residue data which are multiplicatively processed with respect to the moduli $m_1 \cdot m_2$ and $m_2$ correspondingly to the expression (26). The ROM table circuit 30 can be configurated the simpler.

Now, some decoder circuits of this kind are provided with function of the so-called round processing by which after a predetermined bit in addition data is added with the value 1 in outputting binary data, bits below the addition bit concerned are cut off for outputting.

But, in order that the addition data obtained in this way is applied with round processing to output thereof after adding the value 1 directly to the predetermined bit therein, an extra adder having the same bit length as the adder 22 has to be provided, and there is a problem that the configuration of the whole of the decoder circuit becomes the more complicated.

Then, an adder 71 of, for example, 8 bits is provided between latches 67 and 69, and the value 1 is added to the predetermined bit in the addition data $D_{B0}$ by adding the round processed data $D_3$ to the data before the addition data $D_{B0}$ are obtained (in this case, the addition data $D_{A1}$) instead of the addition data $D_{B0}$.

When, for example, 7, 11, 13, and 15 are selected as the moduli $m_0$, $m_1$, $m_2$, and $m_3$, the maximum value $S_{A1\ max}$ of the addition data $D_{A1}$ input to the adder 71 can be represented by the following relation (29) from the expression (22).

$$S_{A1\ max} \leq 12 \times 15 + 14 \leq 194 \qquad (29)$$

In other words, data having the maximum value 194 are obtained in the addition data $D_{A1}$, which can be represented by the length of 8 bits. Even if the value 61 represented by the following expression (30) is added to the maximum value, it is found that carry which exceeds the most significant bit does not yield.

$$(2^8 - 1) - 194 = 61 \qquad (30)$$

Accordingly, the following relation (31) can be obtained with respect to the value 61.

$$2^6 > 61 > 2^5 \qquad (31)$$

If the value 1 is added in the adder 71 concerned in the range up to the fifth bit counted from the least significant bit represented by $2^5$, it is found that the bit length does not vary in the addition data output from the adder 71.

Accordingly, if the value 1 is added in the range up to the fifth bit counted from the least significant bit in the adder 71, the same result of addition as that in the case where the value 1 is added in the range up to the fifth bit counted from the least significant bit can be obtained in the addition data $D_{B0}$ output from the adder 70 using the adder 70 as it is without replacing its configuration.

For this, since the least common multiple M of the moduli $m_0 \sim m_3$ are represented by the following expression (32), the data having the maximum value of 15014 (that is, the value M-1) can be obtained.

$$M = m_0 \cdot m_1 \cdot m_2 \cdot m_3 = 15015 \qquad (32)$$

Accordingly, when the data having the value 15014 are represented by binary data, the relation represented by the following expression (33) is solved to obtain the value n = 14, from which it is found that the binary data are represented by the data having the length of 14 bits.

$$2^n - 1 \geq 15014 > 2^{n-1} - 1 \qquad (33)$$

Accordingly, in the case where the addition data $D_{B0}$ are applied with round processing after the value 1 is added to the predetermined bit therein, an extra 14-bit adder is needed.

Thus, in the case where the addition data $D_{B0}$ are directly round-processed, a 14-bit adder is required for the round processing. For this, by adding the value 1 to the above predetermined bit in the range up to the fifth bit counted from the least significant bit using the adder concerned 71, the preparation of the 8-bit adder 71 allows addition data $D_{B0}$ added with the value 1 to the desired bit therein to be obtained and the whole configuration to be simplified so much.

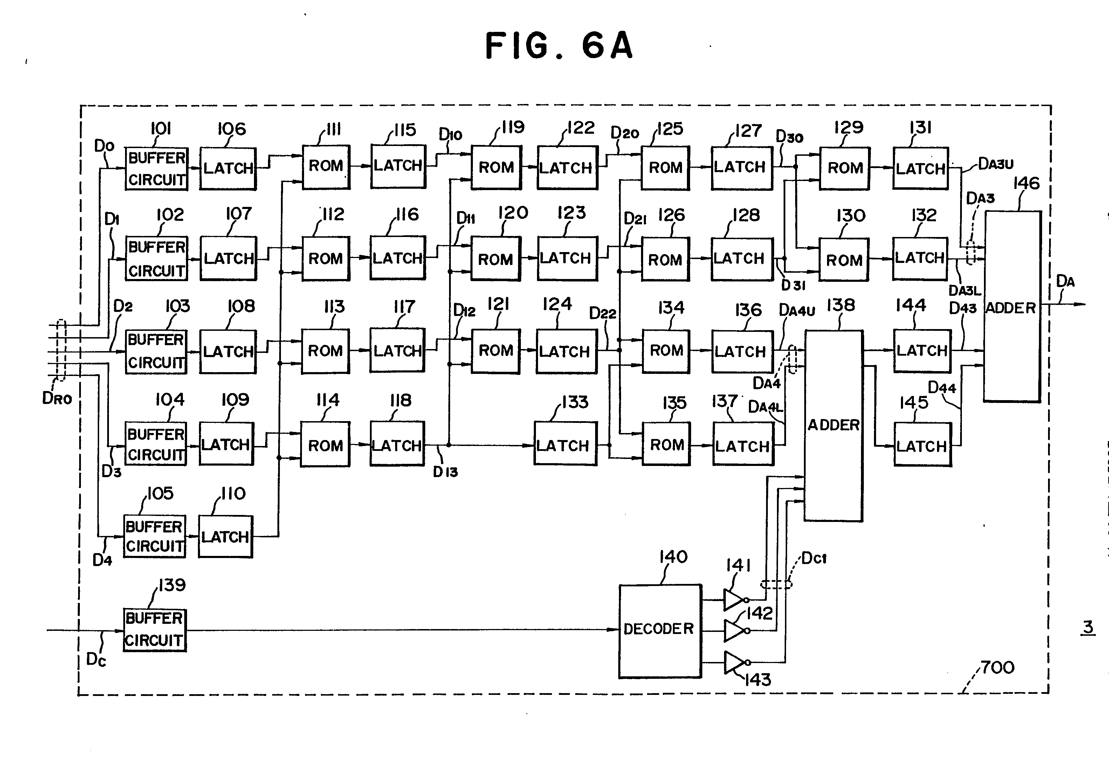

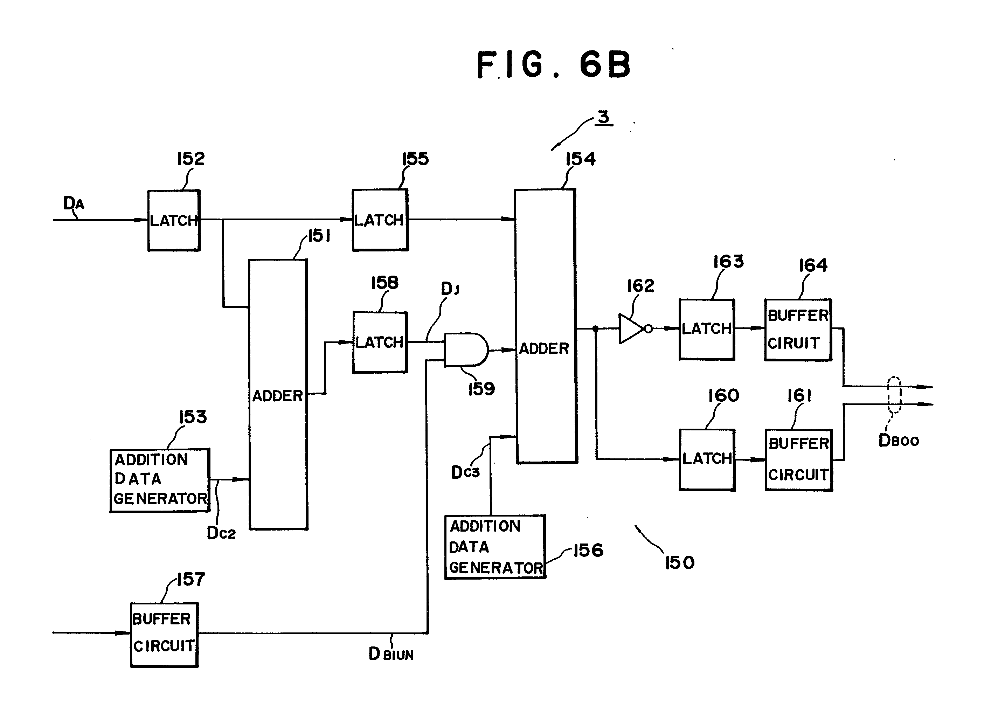

Next, a concrete embodiment of a decoder circuit according to the present invention applied with this fundamental principle will be described using Figs.6A and 6B.

The decoder circuit 3 consists of the data conversion circuit part 100 shown in Fig.6A and the latter half part 150 shown in Fig.6B.

The RNS data $D_{R0}$ represented using the moduli $m_0$, $m_1$, $m_2$, and $m_3$ of the values 7, 11, 13, and 15 and the modulus $m_4$ of the value 16, the value of the power of 2 are employed here.

In other words, in the data conversion circuit part 100, the residue data D0, D1, $D_2$, $D_3$, and $D_4$ (that is, corresponding to the moduli $m_0$, $m_1$, $m_2$, $m_3$, and $m_4$) which compose the RNS data $D_{R0}$ are input to latches 106, 107, 108, 109, and 110 via buffer circuits 101, 102, 103, 104, and 105, respectively.

ROM table circuits 111, 112, 113, and 114 receive residue data $D_4$ of the modulus $m_4$ of the value 16 in addition to the residue data D0, D1, $D_2$, and $D_3$ and output residue data $D_{10}$, $D_{11}$, $D_{12}$, and $D_{13}$ of the moduli $m_0$, $m_1$, $m_2$, and $m_3$, respectively.

In other words, with multiplicative inverse elements of the value 16 (that is, pertaining to the modulus $m_4$)pertaining to the moduli $m_0$, $m_1$, $m_2$, and $m_3$ of values 7, 11, 13, and 15 respectively set to values $X_{04}$, $X_{14}$, $X_{24}$, and $X_{34}$, respectively, residue data $D_{10}$, $D_{11}$, $D_{12}$, and $D_{13}$ having values $R_{10}$, $R_{11}$, $R_{12}$, and $R_{13}$ represented by the following expressions (34), (35), (36), and (37) respectively are output and scale-down processed with respect to the modulus $m_4$ of the value 16 represented by a power of 2.

$$R10 = \{(R_0 - R_4) \cdot X_{04}\} \text{ MOD } m_0 \qquad (34)$$
$$R11 = \{(R_1 - R_4) \cdot X_{14}\} \text{ MOD } m_1 \qquad (35)$$
$$R12 = \{(R_2 - R_4) \cdot X_{24}\} \text{ MOD } m_2 \qquad (36)$$
$$R13 = \{(R_3 - R_4) \cdot X_{34}\} \text{ MOD } m_3 \qquad (37)$$

ROM table circuits 119, 120, and 121 receive the residue data $D_{10}$, $D_{11}$, and $D_{12}$ via latches 115, 116, and 117 respectively, and at the same time, receive the residue data $D_{13}$ via a latch curcuit 118, then they output residue data $D_{20}$, $D_{21}$, and $D_{22}$ of the moduli $m_0$, $m_1$, and $m_2$.

In other words, with multiplicative inverse elements of the value 15 (that is, the modulus) oertaining to the moduli $m_0$, $m_1$, and $m_2$ of values 7, 11, and 13 set to values $X_{03}$, $X_{13}$, and $X_{23}$ respectively, residue data $D_{20}$, $D_{21}$, and $D_{22}$ having values $R_{20}$, $R_{21}$, and $R_{22}$ represented by the following expressions (38), (39), and (40) respectively are output and scale-down processed with respect to the modulus $m_3$.

$$R_{20} = \{(R_{10} - R_{13}) \cdot X_{03}\} \text{ MOD} m_0 \qquad (38)$$
$$R_{21} = \{(R_{11} - R_{13}) \cdot X_{13}\} \text{ MOD} m_1 \qquad (39)$$
$$R_{22} = \{(R_{12} - R_{13}) \cdot X_{23}\} \text{ MOD} m_2 \qquad (40)$$

Furthermore, ROM table circuits 125 and 126 receive residue data $D_{20}$ and $D_{21}$ via latches 122 and 123 respectively, and at the same time, residue data $D_{22}$ via a latch 124, and output residue data $D_{30}$ and $D_{31}$ of the moduli $m_0$ and $m_1$.

In other words, with multiplicative inverse elements of the value 13 (that is, the modulus $m_2$) pertaining to the moduli $m_0$ and $m_1$ of the values 7 and 11 set to values $X_{02}$ and $X_{12}$, residue data $D_{30}$ and $D_{31}$ having values $R_{30}$ and $R_{31}$ represented by the following expressions (41) and (42) are output and scale-down processed with respect to the modulus $m_2$.

ROM table circuits 129 and 130 receive the residue data $D_{30}$ and $D_{31}$ concerned via latches 127 and 128, and output addition data $D_{A3u}$ and $D_{A3L}$ which are higher order 6 bits and lower order 8 bits of the addition data $D_{A3}$ having the value $S_{A3}$ represented by the following expression (43) to latches 131 and 132 respectively.

$$S_{A3} = R_{30} \cdot m_1 \cdot m_2 \cdot m_3 + R_{31} \cdot m_2 \cdot m_3$$
$$= R_{30} \cdot 11 \cdot 13 \cdot 15 + R_{31} \cdot 13 \cdot 15 \qquad (43)$$

For this, ROM table circuits 134 and 135 receive residue data $D_{22}$ and $D_{13}$ via latches 124 and 133, and output addition data $D_{A4u}$ and $D_{A4u}$ which are higher order 4 bits and lower order 4 bits of addition data $D_{A4}$ having the value $S_{A4}$ represented by the following expression (44) to an adder 138 via latches 136 and 137.

$$S_{A4} = R_{22} \cdot m_3 + R_{13} = R_{22} \cdot 15 + R_{13} \qquad (44)$$

On the other hand, a buffer circuit 139 is supplied with a control signal Dc of two bits for round processing. A decoder 140 selectively outputs the value of addition data Dc of three bits in accordance with the value of the above control signal and supplies it to the adder 138 via inverted amplifier circuits 141, 142, and 143.

The adder 138 receives the addition data Dc concerned, which is added with addition data D and D output from the ROM table circuits 134 and 135, both being bit-shifted by three bits from their least significant bit. The output of the adder 138 is output to latch circuits 144 and 145.

Finally, in an adder 146, when the value of the addition data D output from the decoder circuit 140 is 0, the result of addition of the value $S_A$ represented by the following relation (45) can be obtained from the expressions (43) and (44).

$$S_A = R_{30}m_1 \cdot m_2 \cdot m_3 + R_{31} \cdot m_2 \cdot m_3 + R_{22} \cdot m_3 + R_{13}$$
$$= R_{30} \cdot 11 \cdot 13 \cdot 15 + R_{31} \cdot 13 \cdot 15 + R_{22} \cdot 15 + R_{13} \quad (45)$$

Accordungly, when the above result of addition is subjected to operation processing so as to be represented by the following relation (46), the RNS data $D_{R0}$ can be demodulated into binary data having the value $S_A$.

$$SA = S_A \, m_4 + R_4$$
$$= (R_{30} \cdot 11 \cdot 13 \cdot 15 + R_{31} \cdot 13 \cdot 15 + R_{22} \cdot 15$$
$$+ R_{13}) \cdot 16 + R_4$$
$$= R_{30} \cdot 11 \cdot 13 \cdot 15 \cdot 16 + R_{31} \cdot 13 \cdot 15 \cdot 16$$
$$+ R_{22} \cdot 15 \cdot 16 + R_{13} \cdot 16 + R_4 \text{---} \quad (46)$$

Accordingly, in this case, if the result of addition $S_A$ is added with residue data $D_4$ having the value $R_4$ after it is bit-shifted by four bits correspondingly to the value 4 of the exponential part of the module represented by a power of 2, addition data represented by the MRC method can be obtained.

In other words, in addition data obtained from the RNS data represented by the moduli $m_0 \sim m_4$ using the MRC method, since the least common multiple of the moduli $m_0 \sim m_4$ are represented by the following expression (47), the following relation (48) is solved to obtain the value n = 18. The RNS data $D_{R0}$ can be represented by binary data of 18 bits as a whole.

$$M = \prod_{i=0}^{4} m_i$$

$$m_i = 7 \cdot 11 \cdot 13 \cdot 15 \cdot 16 = 240240 \quad (47)$$
$$2^{n-1} - 1 \leq 240239 \leq 2^n - 1 \quad (48)$$

The addition data $D_4$ of 14 bits are output by omitting four bits of the addition data in advance.

In other words, when the addition data represented by the expression (46) are subjected to processing of scaling to omit four bits, processing of scaling of dividing by the value 16 can be executed by only adding addition data $D_{A3u}$, $D_{A3L}$, $D_{A4u}$, and $D_{A4L}$ as they are, which are output from ROM table circuits 129, 139, 134, and 135 and represented by the expression (45).

Thus, the modulus $m_4$ is set to the value 16, and at the same time, scale-down processing is firstly applied to the modulus $m_4$ concerned, thereby allowing the configuration of an adder in processing of scaling to be simplified, and the whole of the configuration of the decoder 3 to be simplified so much.

On the other hand, the decoder circuit 140 is designed in such a manner that the values of the addition data Dc1 are sequentially changed-over between the values 1, 0, 0, 0, 1, 0, and 0, 0, 1 in order from the most significant bit for outputting them, and the value 1 is added to the fifth bit, fourth bit, and third bit counted from the least significant bit as a whole by shifting the addition data Dc1 concerned by three bits and adding them to the addition data $D_A$.

Furthermore, the decoder circuit 140 is so desined that the value of the addition data Dc can be changed over to the value 0, 0, 0 and the addition data $D_A$ not subjected to round processing can be selected.

This embodiment is so designed that since the addition data $D_A$ of 14 bits are output as they are without omitting bits below the bit added with the value 1, bits up to the necessary bit from the most significant bit can be selectively employed in accordance with the bit added with the value 1.

Now, in the case where negative numbers are dealt with in the decoder circuit 3. the discrimination between positive numers and negative numbers has to be done by the judgement whether the value of demodulated natural binary addition data is larger than the fixed value (in this case, the value (M-1)/2 + 1)) or not. For the judgment in practice, a comparator circuit having large bit numbers is needed, which brings up a problem that the configuration of the whole of the decoder circuit is complicated so much, and the configuration of the whole of the signal processing circuit becomes complicated as well.

Then, in the decoder circuit 3 according to the present invention, the addition data $D_A$ output from the data conversion circuit part 100 are added with the fixed value, and positive numbers are discriminated from negative numbers by the most significant bit of the added value obtained.

In other words, as shown in Fig.6B, in the circuit part 150 in the following stage which receives the addition data $D_A$ from the data conversion circuit part 100, an adder 151 receives the higher order 12 bits of the addition data $D_A$ via a latch circuit 152, and at the same time, receives addition data $Dc2$ having the value 171 output from an addition data generating circuit 153. Data of tThe most significant bit of the result of addition are sent as a discriminating signal $Dj$.

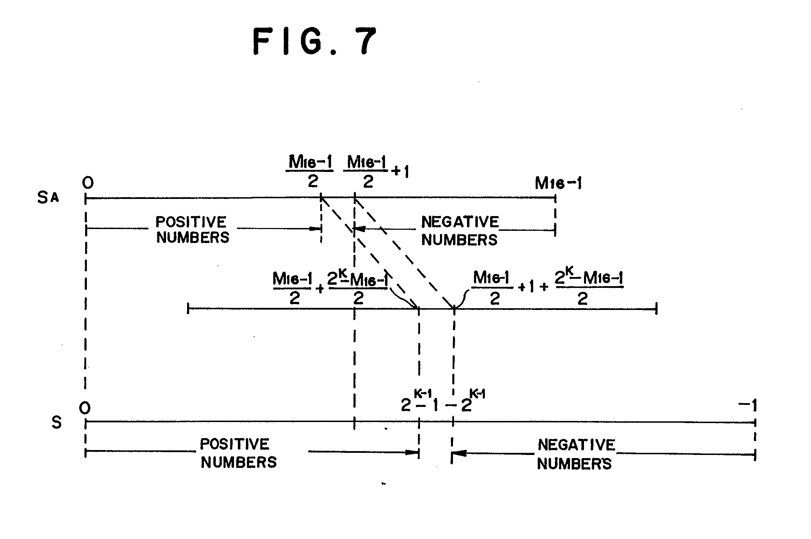

This will be described using Fig.7. Since the addition data $D_A$ obtained by demodulating RNS data are addition data of which higher order 14 bits are subjected to processing of scaling, the addition data represent negative numbers when the addition value $S_A$ is between $(M_{16} - 1)/2 + 1$ and $(M_{16} - 1)$. In this case, the value $M_{16}$ is 15015 of 1/16 times the minimum common multiple $M = 240240$ of the moduli $m_1 \sim m_4$ since the addition data $D_A$ are subjected to processing of scaling by four bits. On the other hand, in the k-bit binary data, negative numbers are represented when the value $S$ at which the most significant bit is given the value 1 is between $2^k$ and $2^k$-1.

Accordingly, if the addition data $D_A$ are added with the fixed value in such a manner that the minimum value which represents negative numbers of the addition data $D_A$ concerned, that is, $(M_{16} - 1)/2 + 1$ becomes the minimum value of the binary data concerned which represent negative numbers (that is, the value $2^{k-1}$- 1), and the addition data $D_A$ are converted into the fixed data (hereinafter called as conversion data), in the value $S_{TR}$ of the conversion data concerned, the value of the most significant bit is changed over from 0 to 1 in the case where the value of the addition data $D_A$ represents negative numbers.

If the operation is done in this way, it is possible to discriminate positive numbers from negative numbers using a only simple configuration by which the addition data $D_A$ are added with the fixed value without comparing all of 14 bits to output the most significant bit allowing the decoder circuit 3 having a simple configuration as a whole to be obtained.

In the case where the discrimination is carried out using higher order 12 bits, it is sufficient to add the value 171, that is, the value obtained by dividing 685 by 2 by cutting two bits, while it is essentially necessary to add 684 up to 14 bits. This reduces size of hardware.

An adder 154 receives the addition data $D$ via a latch circuit 155. The addition data $D_A$ concerned are added with addition data $Dc3$ output from an addition data generating circuit 156, and the added data are output from the adder 154. In other words, the adder 154 receives via an AND circuit 159 a bipolar switching signal $D_{BIUN}$ obtained via a buffer circuit 157 together with a discriminating signal $Dj$ obtained from the adder 151 via a latch circuit 158 and adds to the addition data $D_A$ the value 1369 (that is, $2^k - M_{16}$) which is output from the addition data generating circuit 156 at the timing when the logic level of the discriminating signal $Dj$ rises to logic 1 and output the added data.

As a result, in the adder circuit 154, when the addition data $D_A$ represent negative numbers, binary data added with the value 1369 are obtained for the addition data $D_A$. On the contrary, when the addition data $D_A$ represent positive numbers, the addition data $D_A$ are output as they are.

Thus, the addition data $D_A$ are converted into binary data of 2's complement, which can be output.

For this, the adder 154 outputs the addition data $D_A$ irrespective of the logic level of the discriminating signal $Dj$ as they are when the bipolar switching signal $D_{BIUN}$ is changed over.

As a result, the adder 154 allows bipolar binary data to be switched and output as required by switching the bipolar switching signal $D_{BIUN}$.

The adder 154 outputs higher order 13 bits among the binary data concerned having 14 bits via a latch circuit 160 and a buffer circuit 161, and at the same time, outputs the most significant bit of the binary data concerned via an inverted amplifier 163, a latch circuit 164, and a buffer circuit 165, thereby outputting binary data $D_{B00}$ comprising bipolar binary data and offset binary data.

When a fixed bit of data having a short bit length before the addition data $D_A$ are obtained is added with the value 1, the addition data $D_A$ having a large value as a whole are obtained in accordance with the addition bit concerned, and sometimes it is judged by mistake that the addition data $D_A$ representing the larger value of a positive number represent negative number

In other words, in the case where the value 1 is added to, for example, the $(y + 1)$ bit counted from the most significant bit to apply processing of rounding to $L$ bits to the addition data $D_A$, the addition data $D_A$ are represented by the data of the value added with the value $2^{k-y-1}$ to the whole of the addition data because the $(y + 1)$th bit is added with the value 1. Thus, the maximum value and the ninimum value

12

change from the value $(M-1)/2$ and $(M-1)/2 + 1$ to $(M-1)/2 + 2^{k-y-1}$ and $(M-1)/2 + 1 + 2^{k-y-1}$, respectively.

Accordingly, when the addition data have a larger value than the value $(M-1)/2 + 1 + 2^{k-y-1}$, the value of the addition data D from the addition data generating circuit 153 is set so as to allow the region representing negative numbers to be discriminated, and at the same time, if the value of the addition data from the addition data generating circuit 156 is set to the value $(2^k - M - 2^{k-y-1})$ in such a manner that the maximum value $(M - 1 + 2^{k-y-1})$ of the addition data $D_A$ becomes the value $(2^{k-1} - 2^{k-y-1})$ smaller than the maximum value $(2^k - 1)$ of the binary data $D_{B0}$ by the value $2^{k-y-1}$ (that is, the addition data $D_A$ is assigned to the region having a smaller value of a negative number than the regular value by the value increased as a whole), bipolar binary data obtained by adding the value 1 to $(y + 1)$th bit counted from the most significant bit can be obtained.

Variations described below are considered in the encoder and decoder described above.

When positive and negative numbers are assigned to regions represented by RNS data in the above-mentioned embodiment, the case where the fixed value (that is, the value $(M - 2^n)$ is added to data of higher order bits is described. The method by which positive and negative numbers are assigned is not restricted to the above method. For example, there are the case where after the fixed value $(M - 2^n)$ is added to data of lower order bits, residue data are obtained from the result of addition concerned and the case where the value $(M - 2^n)$ is added to the added value of the residue data which are obtained from data of higher order bits and data of lower order bits. This method is widely applicable to these cases and the like.

Further, in the above-mentioned embodiment, there has been described the case where unipolar binary data obtained by the MRC method are converted into bipolar binary data. But, the means by which RNS data are converted is not restricted to this. For example, the residue theorem by a Chinese and the like can be widely applicable.

Further, in the above-mentioned embodiment, there has been described the case where RNS data are subjected to processing of scaling in converting thereof into binary data and at the same time, subjected to processing of rounding. The present invention is not restricted to this case, but RNS data may be subjected to processing of scaling or rounding as required.

Further, in the above-mentioned embodiment, there has been described the case where addition data are converted into bipolar binary data to output them. The present invention is not restricted to this case, but RNS data may be, for example, directly output as required.

Further, in the above-mentioned embodiment, there has been described the case where the fixed bit of the addition data $D_{A4}$ output from the ROM table circuits 134 and 135 is added with the value 1. The present invention is not restricted to this case, but, for example, the fixed bit of the residue data $D_{13}$ may be added with the value 1.

Further, in the above-mentioned embodiment, there has been described the case where the fixed bit is added with the value 1 in such a manner that bits do not overflow in the adder 138. The present invention is not restricted to this case, but bits are made to overflow as required, and addition data having a so long bit length may be output to the adder 146. Even if the addition data are output like this, processing of addition may be applied to addition data having the bit length of eight bits compared with the case where processing of addition is applied to addition data having the bit length of 14 bits, thereby allowing the whole configurastion to be simplified so much.

Further, in the above-mentioned embodiment, there has been described the case where binary data of 13 bits are output by obtaining addition data of 14 bits of which fixed bit is added with the value 1. The bit length which is output is not restricted to this, but the length of the bit which is output as required may be switched in accordance with the bit added with the vvalue 1.

Further, in the above-mentioned embodiment, there has been described the case where negative numbers are detected by adding the value 171 to the data of the higher order 12 bits of the unipolar binary data of 14 bits. The present invention is not restricted to this, but negative numbers may be detected by adding the value 684 to binary data of 14 bits, the bit length is selected within a sufficient range in practical application, and at the same time, the added value may be set in accordance with the above bit length.

Further, in the above-mentioned embodiment, there has been described the case where unipolar binary data having the region of the value 15015 represented by an odd number of $1/16$ times the minimum common multiple of the moduli $m_0 \sim m_4$ to which positive and negative numbers are assigned and converted into bipolar binary data by the application of processing of scaling thereto. But, in the case where the region concerned is represented by an even number, the value $(2^k - M)/2$ is added in place of the value $(2^k - M - 1)/2$, and the most significant bit of the result of addition may be used as a discriminating signal $D_j$.

Further, in the above-mentioned embodiment, there has been described the case where RNS data are obtained with respect to five moduli of the values 7, 11, 13, 15, and 16. The number and the value of the moduli are not restricted to this, and they can be selected to various values as required.

Further, in the above-mentioned embodiment, there has been described the case where digital video signals composed of binary data of 14 bits are converted into RNS data. The bit length of binary data is not restricted to this, but that in the wide range is applicable.

Further, in the above-mentioned embodiment, there has been described the case where the present invention ia applied to encoder circuits and decoder circuits in digital filter circuits. The present invention is not restried to this, but is widely applicable to digital signal processing circuits for audio signals, video signals, and the like.

## Claims

1. An encoder circuit so designed as to convert input data composed of binary codes into RNS datas, and provided with :
a dividing means for dividing said input data into a plurality of data using fixed bits;
a first ROM table circuit for applying weighted processing to said plurality of data and converting them into residue data for each fixed modulus; and
a second ROM table circuit for converting said addition value of said residue data for each said modulus into residue data of each corresponding modulus;
and characterized in outputting residue data obtained via said second ROM table circuit as residue data composing said RNS data.

2. A decoder circuit so designed as to demodulate RNS data into binary data using the MRC method characterized in that after one of moduli of each residue data composing said RNS data is selected to the value represented by the power of 2, and said residue data are applied with scale-down processing pertaining to the modulus of the value represented by said power of 2, said residue data are applied in order with scale-down processing pertaining to each remaining modulus.

3. A decoder circuit designed in such a manner that after RNS data are applied in order with scale-down processing to obtain a plural of residue data corresponding to each modulus of the RNS data, and said residue data are applied with processing of addition by fixed moduli respectively, addition data are obtained, thereby demodulsting the RNS data into binary data and provided with an adder for adding the value 1 to a fixed bit for fixed data in the period from said scale-down processing till the acquisition of said addition data.

4. A decoder circuit so designed as to convert RNS data into bipolar binary data comprising:
a data converting circuit for converting said RNS data into unipolar binary data;
a discriminating circuit for adding a fixed value to binary data output from said data converting circuit and outputting data of the most significant bit of the result of addition; and
an adder for adding a fixed value to said unipolar binary data and outputting thereof as said bipolar binary data.

5. A decoder circuit comprising:
a data converting circuit for converting RNS data into binary data;
an adder so designed as to add athe value 1 to the fixed bit of said binary data; and
a second data converting circuit for adding the fixed value to binary data of which said fixed bit added with the vslue 1 in accordance with the bit added with said the value 1, thereby converting said binary data into bipolar binary data.

No. 88 116 961.9
SONY CORPORATION
S88P267EP00

FIG. 1

No. 88 116 961.9
SONY CORPORATION
S88P267EP00

# FIG. 2

# FIG. 3

# FIG. 4

EP 0 312 030 A2

NO. 88 116 961.9.
SONY CORPORATION
S88P267EP00

# FIG. 5

EP 0 312 030 A2

No. 88 116 961.7

SONY CORPORATION

S88P267EP00

# FIG. 6A

EP 0 312 030 A2

No. 88 116 961.9
SONY CORPORATION
S88P267EP00

3

## F.I.G. 6B

# FIG. 7

EP 0 312 030 A2